# EUROPÄISCHE PATENTSCHRIFT

(11) **EP 2 116 117 B1**
(45) Veröffentlichungstag und Bekanntmachung des Hinweises auf die Patenterteilung: **28.07.2010**
(21) Anmeldenummer: 07803466.7
(22) Anmeldetag: 13.09.2007
(51) Int. Cl.: H05K 13/08, H05K 13/04

(54) **ERKENNUNG EINES ELEKTRONISCHEN BAUELEMENTES MITTELS UNTERSCHIEDLICHER BAUELEMENTBESCHREIBUNGEN**
IDENTIFICATION OF AN ELECTRONIC COMPONENT USING DIFFERENT COMPONENT DESCRIPTIONS
IDENTIFICATION D'UN COMPOSANT ÉLECTRONIQUE AU MOYEN DE DIFFÉRENTES DESCRIPTIONS DE COMPOSANT

(30) Priorität: 02.02.2007 DE 102007005386
(43) Veröffentlichungstag der Anmeldung: 11.11.2009
(73) Patentinhaber: Siemens Electronics Assembly Systems GmbH & Co. KG, 81379 München (DE)
(72) Erfinder: SCHNEKENBURGER, Thomas, 86415 Mering (DE); BRODT, Michael, 82256 Fürstenfeldbruck (DE)
(74) Vertreter: Maier, Daniel Oliver
(86) Internationale Anmeldenummer: PCT/EP2007/059650
(87) Internationale Veröffentlichungsnummer: WO 2008/092514

(56) Entgegenhaltungen:
- EP-A- 0 994 328
- EP-A- 1 424 885
- US-A1- 2002 092 161

## Beschreibung

Die vorliegende Erfindung betrifft ein Verfahren zum Erkennen von elektronischen Bauelementen mittels Bildverarbeitung, wobei ein Modell des zu erkennenden Bauelements mit einem von einer Kamera aufgenommen Bild des Bauelements verglichen wird und bei einer Übereinstimmung des Modells mit dem auf dem Bild dargestellten Bauelement das Bauelement als korrekt erkannt angesehen wird.

Die vorliegende Erfindung betrifft ferner ein Bildverarbeitungssystem sowie einen Bestückautomaten, welche zur Durchführung des erfindungsgemäßen Verfahrens zur Bauelementerkennung eingerichtet ist.

Außerdem betrifft die Erfindung ein computerlesbares Speichermedium sowie ein Programm-Element, welche Instruktionen zur Durchführung des erfindungsgemäßen Verfahrens zum Erkennen von elektronischen Bauelementen enthalten.

Bei der automatischen Bestückung von Bauelementeträgern mittels so genannter Bestückautomaten werden Bauelemente von einer Bauelement-Zuführeinrichtung an bestimmten Abholpositionen bereitgestellt und von einem Bestückkopf abgeholt, welcher mittels eines Positioniersystems innerhalb eines Arbeitsbereiches frei positioniert werden kann. Die abgeholten Bauelemente werden von dem Bestückkopf zu einer Bestückposition transportiert und auf dem zu bestückenden Bauelementeträger an Einbaupositionen aufgesetzt, welche durch entsprechende elektrische Anschlussflächen definiert sind.

Aufgrund der zunehmenden Miniaturisierung von elektronischen Bauelementen ist ein präziser Bestückvorgang nur durch eine genaue optische Lagevermessung der von dem Bestückkopf aufgenommenen Bauelemente möglich. Ebenso ist eine präzise Lagevermessung des zu bestückenden Bauelementeträgers erforderlich, damit von dem Bestückkopf die Bestückpositionen präzise angefahren werden können. Die Lagevermessung von Bauelementeträgern erfolgt üblicherweise anhand spezieller an den jeweiligen Bauelementeträgern angebrachten Markierungen. Zur Lagevermessung von elektronischen Bauelementen, die von einem Bestückkopf aufgenommen wurden, wird der Bestückkopf bzw. die entsprechende Bauelement-Haltevorrichtung relativ zu einer sog. Bauelemente-Kamera derart positioniert, dass sich das zu erkennende Bauelement in dem Gesichtsfeld der Kamera befindet. Die eigentliche Erkennung erfolgt dann mittels Bildverarbeitungsprozessen (siehe z.B. das Dokument US2002/092161).

Für eine genaue und robuste, d.h. wenig fehleranfällige Erkennung von elektronischen Bauelementen in Bestückautomaten ist es üblich, die Geometrie des Bauelements detailliert in einem geometrischen Modell zu beschreiben. Das Bildverarbeitungssystem verwendet dieses geometrische Modell bei einer Vielzahl von einzelnen Erkennungsschritten. Aus dem geometrischen Modell lassen sich die relativen Lagen der jeweiligen Merkmale wie beispielsweise Bauelementanschlussfüße, Bauelementanschlusskugeln oder Ecken ermitteln. Dabei sind die ermittelten relativen Lagen mit Toleranzen des geometrischen Modells behaftet. Da die genaue räumliche Lage des Bauelements infolge von so genannten Zuführtoleranzen bei der Bereitstellung und der Abholung von Bauelementen zunächst üblicherweise nicht bekannt ist, muss in einem ersten Erkennungsschritt zumindest ein Merkmal des Bauelements in einer relativ großen Region des aufgenommenen Bildes gesucht werden. In weiteren Erkennungsschritten wird dann abhängig von der Form und Größe des jeweiligen Merkmal-Modells wird danach in genauer bestimmten Regionen des Bildes dann nach zumindest einem bestimmten Merkmal des Bauelements gesucht. Dazu können beispielsweise geometrische Filter verwendet werden.

Oft weisen elektrisch gleiche Bauelemente von verschiedenen Lieferanten oder aus verschiedenen Chargen geometrische Unterschiede auf, so dass es nicht möglich ist, ein Modell zu finden, das für alle Varianten des Bauelements verwendbar ist. Man könnte zwar bei der Bauelementerkennung die Toleranzen für die Abmaße von bestimmten Merkmalen erhöhen, allerdings besteht dann die Gefahr von Fehlerkennungen, die beispielsweise bei einer nachfolgenden Positionsbestimmung zu Ungenauigkeiten führen, die außerhalb der Genauigkeitsspezifikation für das betreffende Bauelement sind.

Ist die Erstellung eines Modells für verschiedene Varianten eines Bauelement-Typs nicht möglich, müssen für das Bauelement verschiedene Modelle erstellt werden. Bei einem Chargenwechsel muss dann manuell auf ein anderes Modell umgeschaltet werden. Dies ist jedoch sehr aufwändig und fehlerträchtig.

Der Erfindung liegt die Aufgabe zugrunde, die Erkennung von elektronischen Bauelementen mittels Bildverarbeitung dahingehend zu verbessern, dass auch dann eine geringe Fehleranfälligkeit gegeben ist, wenn das zu erkennende Bauelement in verschiedenen Variationen vorliegen kann.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Verfahren zum automatischen Erkennen eines elektronischen Bauelementes mittels Bildverarbeitung beschrieben. Das beschriebene Verfahren weist die folgenden Schritte auf: (a) Laden eines Datensatzes mit unterschiedlichen Beschreibungen des optischen Erscheinungsbildes des elektronischen Bauelements in eine Datenverarbeitungseinrichtung, (b) Laden eines von einer Kamera aufgenommenen Bildes von zumindest einem Teil des elektronischen Bauelements in die Datenverarbeitungseinrichtung, und (c) Vergleichen von zumindest einem Merkmal der unterschiedlichen Beschreibungen mit zumindest einem Merkmal des Bildes.

Dabei wird das Bauelement als dem Datensatz entsprechend erkannt, wenn das zumindest eine Merkmal des Bildes innerhalb einer vorgegebenen Toleranz zumindest einem Merkmal des Datensatzes entspricht.

Der Erfindung liegt die Erkenntnis zugrunde, dass bei einer Berücksichtigung von verschiedenen Gehäusebeschreibungen für ein zu erkennendes Bauelement die Zuverlässigkeit bzw. die Robustheit der Bauelementerkennung insbesondere dann erheblich gesteigert werden kann, wenn das zu erkennende Bauelement in verschiedenen Ausführungsformen vorliegen kann. Die prinzipiell möglichen Ausführungsformen sind dabei typischerweise a priori bekannt, wohingegen die spezielle Ausführungsform des gerade betrachteten Bauelements nicht bekannt ist. Gemäß der vorliegenden Erfindung werden Beschreibungen dieser alternativen Ausführungsformen in einen Datensatz aufgenommen, so dass bei einer Bauelementerkennung auch dann ein hohes Maß an Übereinstimmung erreicht werden kann, wenn das Bauelement lediglich einer Ausführungsvariante von einer Vielzahl von verschiedenen Ausführungsvarianten entspricht.

Die Möglichkeit der Berücksichtigung von verschiedenen Ausführungsvarianten hat den Vorteil, dass die Bauelementerkennung auch dann in einer zuverlässigen und robusten Art und Weise durchgeführt werden kann, wenn sich die verschiedenen Ausführungsvarianten stark voneinander unterschieden. Im Extremfall sind die Ausführungsvarianten so unterschiedlich, dass man im Ergebnis von vollkommen unterschiedlichen bzw. diskret verschiedenen Varianten sprechen kann.

Der Begriff optisches Erscheinungsbild umfasst dabei alle optisch erfassbaren Charakteristika des zu erkennenden Bauelements. Dazu zählen neben der geometrischen Form bzw. Struktur einzelner Bereiche des Bauelements auch optische Eigenschaften wie beispielsweise Farbe, Helligkeit und Kontrast.

Es wird darauf hingewiesen, dass unter dem Begriff Bild nicht nur für das menschliche Auge sichtbare graphische Informationen verstanden werden. Der Begriff Bild kann vielmehr auch Informationen umfassen, die in Form von beliebig definierten oder verschlüsselten Bilddaten im Rahmen einer Bildverarbeitung ein Abbild des betreffenden Bauelements repräsentieren.

Es wird ferner darauf hingewiesen, dass das beschriebene Verfahren für verschieden große Bauelemente angewendet werden kann. Im Falle von kleineren Bauelementen, welche vollständig in das Gesichtsfeld der Kamera passen, enthält bereits eines von der Kamera aufgenommene Bild sämtliche optische Informationen über das betreffende Bauelement. Im Falle eines größeren Bauelements, welches nicht mit einem einzigen Bild aufgenommen werden kann, kann eine so genannte Mehrfachmessung erforderlich sein, um das betreffende Bauelement vollständig optisch zu erfassen. Die Erkennung des Bauelementes beruht dann im Allgemeinen auf der gemeinsamen Bildverarbeitung von mehreren Teilbildern, welche jeweils unterschiedliche Ausschnitte des Bauelements zeigen und welche in die Datenverarbeitungsrichtung geladen werden.

In diesem Zusammenhang wird außerdem darauf hingewiesen, dass die oben beschriebe Mehrfachmessung, bei der mehrere Bilder von einem bestimmten Bauelement gemeinsam in der Datenverarbeitungseinrichtung verarbeitet werden, auch bei kleinen Bauelementen sinnvoll sein kann, die vollständig in das Gesichtsfeld der Kamera passen. So können beispielsweise verschiedene Beleuchtungsszenarien verwendet werden, um mit verschiedenen Aufnahmen unterschiedliche charakteristische Merkmale eines Bauelementes möglichst deutlich erfassen zu können.

Das Vergleichen von zumindest einem Merkmal der unterschiedlichen Beschreibungen mit zumindest einem Merkmal des Bildes kann auf vielfältige Weise durchgeführt werden. Insbesondere kann das Vergleichen eine Mehrzahl von einzelnen Bildverarbeitungsschritten umfassen. Bevorzugt werden dabei aus dem Modell Parameter für Bildverarbeitungsoperatoren abgeleitet, welche Parameter zur Suche bestimmter Merkmale in dem Bild verwendet werden. Die Bildverarbeitungsoperatoren können beispielsweise geometrische Filter oder Profil-Operatoren sein.

Das beschriebene Verfahren zur Bauelement-Erkennung kann auf einfache Weise in bereits bestehende Vision Systeme von Bestückautomaten implementiert werden. Ein apparativer Umbau der Vision Systeme ist dabei nicht erforderlich. Die Implementierung kann vielmehr durch eine Anpassung der Bildverarbeitungssoftware realisiert werden.

Es wird darauf hingewiesen, dass für den Fall, dass der Vergleich eines Merkmals der unterschiedlichen Beschreibungen mit zumindest einem Merkmal des Bildes keine Übereinstimmung ergibt, dass Bauelement als nicht erkannt angesehen wird. Diese Information kann im Rahmen eines Bestückprozesses dazu verwendet werden, dass das nicht erkannte Bauelement verworfen wird. Es ist jedoch auch möglich, dass das nicht erkannte Bauelement mit anderen modellhaften Beschreibungen der Bauelement-Gehäuseformen verglichen und entsprechend charakterisiert wird.

Für den Fall, dass ein Merkmal des Bildes mehreren unterschiedlichen Beschreibungen zugeordnet werden kann, kann diejenige Beschreibung ausgewählt werden, welche den höchsten Grad an Übereinstimmung mit dem Bildmerkmal aufweist. Zur Ermittlung des Grades der Übereinstimmung kann auf bekannte Verfahren zur Objektidentifizierung bei Bildverarbeitungsvorgängen zurückgegriffen werden.

Es wird darauf hingewiesen, dass, falls ein Merkmal des Bildes mehreren unterschiedlichen Beschreibungen zugeordnet werden kann, für das beschriebene automatische Bauelement-Erkennungsverfahren eine zusätzliche Fehlermöglichkeit gegeben ist. Aus diesem Grund ist es vorteilhaft, wenn in diesem Fall einer Bedienperson eine entsprechende Warnung ausgegeben wird, so dass die Bedienperson die Bauelement-Erkennung auf ihre Richtigkeit überprüfen kann.

Gemäß einem Ausführungsbeispiel der Erfindung nach Anspruch 2 ist die Beschreibung eine geometrische Beschreibung der Gehäuseform des Bauelements. Die Verwendung einer geometrischen Beschreibung hat den Vorteil, dass geometrische Strukturen besonders leicht und besonders zuverlässig erkannt werden können.
Die geometrische Beschreibung kann dabei einen Teilbereich des Bauelements oder das gesamte Bauelement beschreiben. Die äußere Form des Bauelements ergibt sich typischerweise durch die jeweilige Gehäuseform, welche von außen sichtbar ist. Dabei ist unter dem Begriff Gehäuseform nicht nur die Form eines vergleichsweise kompakten Körpers des Bauelements zu verstehen. Der Begriff Gehäuseform kann auch andere periphere Strukturen des Bauelements wie beispielsweise elektrische Anschlüsse oder Kühlkörper umfassen.

Bevorzugt wird die jeweilige geometrische Beschreibung von dem Hersteller der zu bestückenden Bauelemente ermittelt und spätestens bei der Auslieferung der Bauelemente and den Kunden übermittelt. Somit sind mögliche Merkmalsvarianten bereits frühzeitig bekannt und können bei der Bauelementerkennung während eines Bestückbetriebes berücksichtigt werden.

Gemäß einem weiteren Ausführungsbeispiel der Erfindung nach Anspruch 3 stellt das in die Datenverarbeitungseinrichtung geladene Bild ein von einer Bauelement-Haltevorrichtung aufgenommenes elektronisches Bauelement dar. Dies hat den Vorteil, dass die beschriebene Bauelement-Erkennung prinzipiell für alle Bauelemente durchgeführt werden kann, welche von einer geeigneten Bauelement-Haltevorrichtung aufgenommen werden können und welche somit durch eine geeignete Positionierung eines der Haltevorrichtung zugeordneten Bestückkopfes in den Erfassungsbereich einer Kamera transportiert werden können. Die Kamera kann dann ein Bild des aufgenommenen Bauelements aufnehmen, welches, wie oben beschrieben, in die Datenverarbeitungseinrichtung geladen wird.

Gemäß einem weiteren Ausführungsbeispiel der Erfindung nach Anspruch 4 weist das Verfahren zusätzlich den folgenden Schritt auf: Ermitteln der räumlichen Lage des Modells des Bauelements relativ zu dem von der Kamera aufgenommenen Bild.

Durch eine Bestimmung der relativen räumlichen Lage zwischen dem Modell und dem Bild kann die Position des Bauelements innerhalb des Bildes zuverlässig ermittelt werden. Dies ist eine wichtige Voraussetzung für eine hochgenaue Bestückung von Bauelementeträgern, da durch eine genaue Positionsbestimmung eines von einer Bauelement-Haltevorrichtung aufgenommenen Bauelements gegebenenfalls vorhandene Positionsabweichungen des Bauelements von einer Soll-Aufnahmeposition durch eine entsprechende Positionierung eines Bestückkopfes und/oder durch eine entsprechende Drehbewegung der Haltevorrichtung beim Aufsetzen des Bauelements kompensiert werden können.

Die relative räumliche Lage zwischen dem Modell und dem Bild kann dabei dadurch ermittelt werden, dass das Modell in geeigneter Weise in das Bild eingepasst wird. Dies bedeutet, dass das Model und das in dem Bild vorhandene Bauelement derart übereinander gelegt werden, dass zwischen beiden eine maximale Überlappung vorhanden ist.

Gemäß einem bevorzugten Ausführungsbeispiel der Erfindung nach Anspruch 5 umfasst der Datensatz ein Modell des optischen Erscheinungsbildes des elektronischen Bauelements, welches Modell ein Merkmal aufweist, welches verschiedene alternative Varianten umfasst. Ferner wird das Bauelement als dem Datensatz entsprechend erkannt, wenn das Merkmal des Bildes innerhalb einer vorgegebenen Toleranz zumindest einer alternativen Variante des Merkmals entspricht. Auf diese Weise können in dem Datensatz auf effektive Weise verschiedene alternative Bauelementbeschreibungen gespeichert sein, welche zumindest ein gemeinsames Merkmal aufweisen.

Gemäß einem weiteren Ausführungsbeispiel der Erfindung nach Anspruch 6 wird ein Merkmal des Modells aus einer vorgegebenen Region des Modells mit einem Merkmal des Bildes aus einer Bildregion verglichen, welche Bildregion der vorgegebenen Region des Modells zugeordnet ist. Auf diese Weise kann durch eine geeignete Vorselektion von Bereichen des Modells bzw. Bereichen des Bildes, in denen die miteinander zu vergleichenden Merkmale angeordnet sind, die Zuverlässigkeit der Bauelementerkennung bei einem vergleichsweise geringen Rechenaufwand signifikant erhöht werden. Das Merkmal des Modells in der vorgegebenen Region des Modells umfasst dabei, wie oben erläutert, mehrere Ausführungsvarianten.

Die korrekte Zuordnung kann durch eine Berücksichtigung von Ergebnissen von vorangegangenen Bauelement-Erkennungsvorgängen erleichtert werden. Selbstverständlich kann die Zuordnung auch ohne einen derartigen Lernvorgang erfolgen, da typischerweise die Aufnahmegeometrie, d.h. die relative räumliche Anordnung zwischen der Kamera und dem aufgenommenen Bauelement bekannt ist. Die bekannte Aufnahmegeometrie stellt somit ein verwertbares a priori Wissen dar, wo sich zumindest ungefähr das aufgenommene Bauelement in dem Bild befindet.

Gemäß einem weiteren Ausführungsbeispiel der Erfindung nach Anspruch 7 unterscheiden sich die Varianten des Merkmals bezüglich der Form, der Größe, der Lage, der Farbe, der Helligkeit, des Kontrastes und/oder der Kontrastrichtung von bestimmten räumlichen Bereichen des Modells des optischen Erscheinungsbildes des elektronischen Bauelements.

Für die Differenzierung der Merkmale des Modells in unterschiedliche Varianten gibt es demzufolge eine Vielzahl von verschiedenen Möglichkeiten. Somit kann das Modell an eine Vielzahl von verschiedenen Ausführungsformen eines zu erkennenden Bauelements angepasst werden. So kann beispielsweise ein bestimmter Bauelement-Typ auch dann zuverlässig erkannt werden, wenn die entsprechenden Bauelemente beispielsweise von verschiedenen Herstellern oder von verschiedenen Produktionschargen stammen, welche sich bezüglich einzelner Merkmale deutlich voneinander unterscheiden.

Gemäß einem weiteren Ausführungsbeispiel der Erfindung nach Anspruch 8 weist das Modell des optischen Erscheinungsbildes des elektronischen Bauelements zumindest ein weiteres Merkmal auf. Ferner weist das Verfahren zusätzlich den folgenden Schritt auf: Vergleichen des weiteren Merkmals des Modells mit einem weiteren Merkmal des Bildes. Dabei wird das Bauelement als dem Modell entsprechend erkannt, wenn (a) das Merkmal des Bildes innerhalb einer vorgegebenen Toleranz zumindest einer alternativen Variante des Merkmals des Modells entspricht und wenn (b) das weitere Merkmal des Bildes innerhalb einer vorgegebenen weiteren Toleranz dem weiteren Merkmal des Modells entspricht.

Dies bedeutet, dass für eine korrekte Bauelementerkennung eine weitere Bedingung erforderlich ist, wonach zumindest zwei Merkmale des Modells zwei Merkmalen des aufgenommenen Bildes entsprechen müssen. Dabei gilt für eines der Merkmale des in dem Bild dargestellten Bauelementes, dass dieses Merkmal zumindest einer Variante eines entsprechenden Merkmals des Modells entspricht.

Auch hier gilt dass das Vergleichen des weiteren Merkmals des Modells mit dem weiteren Merkmal des Bildes auf vielfältige Weise durchgeführt werden und eine Mehrzahl von verschiedenen Bildverarbeitungsschritten bzw. Operationen umfassen kann. Bevorzugt werden dabei aus dem Modell Parameter für Bildverarbeitungsoperatoren abgeleitet, welche Parameter zur Suche bestimmter weiterer Merkmale in dem Bild verwendet werden. Die Bildverarbeitungsoperatoren können beispielsweise geometrische Filter oder Profil-Operatoren sein.

Gemäß einem weiteren Ausführungsbeispiel der Erfindung nach Anspruch 9 umfasst das weitere Merkmal des Modells verschiedene alternative weitere Varianten. Dies bedeutet, dass eine Übereinstimmung des weiteren Merkmals des Bildes mit dem weiteren Merkmal des Modells dann angenommen wird, wenn das weitere Merkmal des Bildes innerhalb einer vorgegebenen weiteren Toleranz zumindest einer alternativen weiteren Variante entspricht. Somit kann eine Bauelementerkennung bereits dann als korrekt angenommen werden, wenn die in dem aufgenommenen Bild identifizierbaren Merkmale jeweils einer Variante des entsprechenden Merkmals entsprechen.

Gemäß einem weiteren Ausführungsbeispiel der Erfindung nach Anspruch 10 wird mit dem Merkmal des Modells und mit dem zumindest einen weiteren Merkmal des Modells eine Merkmalsgruppe definiert, welche abhängig von der Anzahl der verschiedenen alternativen Varianten des Merkmals eine entsprechende Anzahl von verschiedenen Merkmalskombinationen umfasst. Eine derartige Modellierung eines zu erkennenden Bauelements mittels verschiedenen alternativen Merkmalskombinationen hat den Vorteil, dass zum einen die Sicherheit der Bauelementerkennung entsprechend erhöht wird, da eine korrekte Erkennung nur dann angenommen wird, wenn mehrere Merkmale des Modells in dem Bild erkannt werden. Zum anderen hat die Berücksichtigung von alternativen Varianten für zumindest eines der Merkmale den Vorteil, dass eine zu erwartende Varianz bezüglich des optischen Erscheinungsbildes berücksichtigt werden kann. Bei dem Vergleich zwischen Modell und aufgenommenen Bild wird dann versucht, zumindest eine der alternativen Gruppen bzw. Merkmalskombinationen zu erkennen.

Der beschriebene kombinierte Vergleich verschiedener Merkmale, wobei zumindest ein Merkmal mehrere Varianten umfasst, ist insbesondere dann von Vorteil, wenn das zu erkennende Bauelement eine Mehrzahl von gleichartigen Charakteristika aufweist. Solche Charakteristika sind beispielsweise äußerlich gleichartige Bauelement Anschlüsse, die abhängig von der jeweiligen Gehäuseform des zu erkennenden Bauelements in einer oder in mehreren Reihen oder auch in einem Gitter angeordnet sein können.

Gemäß einem weiteren besonders bevorzugten Ausführungsbeispiel der Erfindung nach Anspruch 11 weist der Datensatz voneinander unabhängige unterschiedliche Beschreibungen des optischen Erscheinungsbildes des elektronischen Bauelements auf. Dies bedeutet, dass sich die verschiedenen unterschiedlichen Beschreibungen derart voneinander unterscheiden können, dass die verschiedenen Beschreibungen keine gemeinsamen Merkmale aufweisen, die einander zugeordnet sind oder die einander zugeordnet werden können.

Gemäß einem weiteren Ausführungsbeispiel nach Anspruch 12 weist das Verfahren zusätzlich folgende Schritte auf: (a) Laden eines Identifikationscodes in die Datenverarbeitungseinrichtung, welcher Identifikationscode einer der unterschiedlichen Beschreibungen des optischen Erscheinungsbildes des elektronischen Bauelements zugeordnet ist, und (b) Selektieren einer bevorzugten Beschreibung basierend auf dem Identifikationscode, wobei die bevorzugte Beschreibung für den Schritt des Vergleichens von zumindest einem Merkmal der unterschiedlichen Beschreibungen mit zumindest einem Merkmal des Bildes bevorzugt verwendet wird.

Diese Ausführungsvariante des erfindungsgemäßen Verfahrens hat den Vorteil, dass gezielt zumindest eine bevorzugte Beschreibung ausgewählt werden kann, welche sich mit einer besonders hohen Wahrscheinlichkeit in dem aufgenommenen Bild des elektronischen Bauelements wieder findet. Damit kann der Erkennungsprozess des Bauelements erheblich beschleunigt und somit ein zumindest vorübergehender Produktionsstillstand bei der Herstellung von elektronischen Baugruppen mit hoher Wahrscheinlichkeit vermieden werden.

Im Vergleich der Verwendung einer Bauelementbeschreibung, welche von einer Bedienperson eingegeben wird, ist bei dem beschrieben Verfahren gewährleistet, dass stets eine korrekte Bauelementbeschreibung zur Bauelementerkennung verwendet wird. Eine falsch eingegebene Bauelementbeschreiung kann nämlich beispielsweise bei der Positionsermittlung des Bauelements relativ zu dem Bestückkopf zu völlig falschen Ergebnissen führen. Durch die automatische und insbesondere eindeutige Auswahl der Bauelementbeschreibung basierend auf den Identifikationskode können derartige Fehler bei der Herstellung von elektronischen Baugruppen weitgehend ausgeschlossen werden.

Der Identifikationskode wird bevorzugt von dem Hersteller der Bauelemente zur Verfügung gestellt. Der Hersteller kann somit unmittelbar nach einer Qualitätsausgangs- bzw. Qualitätsendkontrolle einer hergestellten Charge von Bauelementen eine entsprechende Bauelementbeschreibung anfertigen. Die Bauelementbeschreibung beinhaltet dann die in der betreffenden Charge tatsächlich realisierte Variante eines entsprechenden Bauelementmodells.

An dieser Stelle wird ausdrücklich darauf hingewiesen, dass ein Identifikationskode auch in Verbindung mit einem Modell des zu erkennenden Bauelementes verwendet werden kann, welches Modell zumindest ein Merkmal aufweist, das in verschiedenen alternativen Varianten vorkommen kann. Auch in diesem Fall kann mittels des Identifikationskodes der entsprechenden Datenverarbeitungsrichtung signalisiert werden, welche der alternativen Merkmalsvarianten bei einer bestimmten Charge von Bauelementen bevorzugt vorkommt.

Gemäß einem weiteren Ausführungsbeispiel der Erfindung nach Anspruch 13 ist der Identifikationscode an einem Identifikationselement gespeichert, welches an einem Bauelementmagazin angebracht ist.

Das Identifikationselement kann beispielsweise eine als Aufkleber ausgebildete Markierung sein. Das Bauelementmagazin kann beispielsweise ein Flächenmagazin oder ein Gebinde bzw. eine sog. Gurtrolle sein, auf der in bekannter Weise ein mit Bauelementen befüllter Bauelementgurt aufgewickelt ist. Das Bauelementmagazin kann auch ein herkömmlicher Bauelementgurt sein, an oder in dem das Identifikationselement angeordnet oder aufgenommen ist. Somit kann auf einfache Weise ein vom Hersteller bereit gestellter Identifikationscode, welcher an einem Flächenmagazin oder einer Gurtrolle angebracht ist, zur Selektion einer passenden alternativen Bauelementbeschreibung genutzt werden.

Das Identifikationselement kann beispielsweise einen Barcode oder einen zweidimensionalen Matrix-Kode aufweisen. Selbstverständlich kann der Identifizierungskode auch in beliebigen anderen Arten von Identifizierungselementen wie beispielsweise einem kontaktlosen Übertragungselement bzw. einem Transponder gespeichert sein.

Im Falle der Verwendung von Flächenmagazinen können die Identifizierungselemente derart an den Magazinen angebracht sein, dass sie von einer sog. Leiterplattenkamera ausgelesen werden können. In diesem Zusammenhang ist unter dem Begriff Leiterplattenkamera eine optische Sensorvorrichtung zu verstehen, welche oberhalb der Bestückebene eines Bestückautomaten angebracht ist und welche üblicherweise zum Erkennen von Positionsmarkierungen auf einer in den Bestückbereich des Bestückautomaten eingebrachten Leiterplatte vorgesehen ist.

Gemäß einem weiteren Ausführungsbeispiel der Erfindung nach Anspruch 14 erfolgt das Laden des Identifikationscodes durch einen automatischen Einlesevorgang. Dies bedeutet, dass zum Laden des Identifikationskodes kein manueller Bedieneingriff durch eine Bedienperson erforderlich ist, so dass auf vorteilhafte Weise die Zuverlässigkeit des gesamten Verfahrens zur Bauelementerkennung erhöht wird.

In der Regel können automatische Einlesevorgänge wesentlich schneller durchgeführt werden als Einlesevorgänge, die einen Bedieneingriff einer Bedienperson benötigen. Somit kann die Wahrscheinlichkeit für eine zwischenzeitliche Unterbrechung des Produktionsprozesses reduziert werden. Das Lesen des Identifikationskodes kann dann bevorzugt immer dann durchgeführt werden, wenn dem Bestückautomaten ein neues Flächenmagazin zugeführt wird.

Falls trotz alledem eine Benutzerinteraktion erforderlich sein sollte, dann kann zumindest die Zeitdauer eines vorübergehenden Produktionsstillstandes verringert werden, da dem Benutzer bzw. der Bedienperson zumindest ein geeigneter erscheinender Vorschlag für eine Bauelementbeschreibung gemacht werden kann.

Gemäß einem weiteren Ausführungsbeispiel der Erfindung nach Anspruch 15 wird der Identifikationscode durch ein einer Bauelement-Zuführeinheit zugeordnetes Lesegerät oder durch ein von einer Bedienperson gehandhabtes Handlesegerät eingelesen. Die Verwendung eines einer Bauelement-Zuführeinheit zugeordneten Lesegerätes hat den Vorteil, dass die Bauelementbeschreibung ohne jeglichen Bedieneingriff eingelesen werden kann. Dabei kann als Lesegerät beispielsweise ein Barcode-Scanner verwendet werden, welcher Barcodes erfasst, die auf einer Deckfolie eines Bauelementgurtes angebracht sind.

Das Lesegerät kann jedoch auch ein RFID (Radio Frequency Identifikation Device)-Lesegerät sein, welches RFID Chips bzw. Transponder ausliest, die sich in einer Tasche eines Bauelementgurtes oder in einem Fach eines Bauelement-Flächenmagazins befinden.

Die Verwendung eines Handlesegerätes zum Einlesen des Identifikationskodes hat den Vorteil, dass das Einlesen der Bauelement-Beschreibungen gemeinsam mit einem ohnehin erforderlichen Verifikationsvorgang durchgeführt werden kann, bei dem nach einem Spleißvorgang oder nach einer neuen Rüstung eines Bestückautomaten überprüft wird, ob auch tatsächlich die richtigen Bauelement-Typen an den verschiedenen Zuführspuren einer Bauelement-Zuführvorrichtung bereitgestellt werden. In diesem Zusammenhang wird darauf hingewiesen, dass ein Spleißvorgang in bekannter Weise bevorzugt immer dann durchgeführt wird, wenn im Rahmen eines Bestückungsprozesses die Bauelemente aus einem Gebinde verbraucht wurden. Durch ein Anspleißen eines neuen vollständig gefüllten Bauelementgurtes an das Ende eines zumindest nahezu entleerten Bauelementgurtes kann somit der Produktionsprozess ohne Unterbrechung fortgesetzt werden.

Es wird darauf hingewiesen, dass auch im Falle der Verwendung von Flächenmagazinen ein Handscanner auf effektive Weise die Bauelementbeschreibung einlesen kann. Die Bauelementbeschreibung kann nämlich in analoger Weise zusammen mit einer Bauelementverifikation erfolgen, wenn nach dem Verbrauch der Bauelemente aus einem ersten Flächenmagazin ein zweites Flächenmagazin zugeführt wird.

In diesem Zusammenhang bleibt somit zusammenfassend festzustellen, dass immer dann ein Identifizierungskode eingelesen werden sollte, wenn dem Bestückautomaten neue Bauelemente zugeführt werden.

Mit dem nebengeordneten Patentanspruch 16 wird ein Bilderkennungssystem zum automatischen Erkennen eines elektronischen Bauelementes beschrieben. Das Bilderkennungssystem weist einen Prozessor auf, der derart eingerichtet ist, dass das oben genannte Verfahren zum Erkennen eines elektronischen Bauelementes durchgeführt werden kann.

Gemäß einem Ausführungsbeispiel der Erfindung nach Anspruch 17 weist das Bilderkennungssystem zusätzlich eine Kamera zum Aufnehmen eines Bildes des zu erkennenden Bauelements oder zum Aufnehmen eines Bildes von zumindest zwei zu erkennenden Bauelementen auf.

Das Bilderkennungssystem kann somit als autarke Einheit realisiert werden, die an verschiedenen Stellen eines Bestückautomaten angeordnet sein kann. Bevorzugt ist das Bilderkennungssystem und insbesondere die Kamera derart angeordnet, dass ein von einem Bestückkopf aufgenommenes Bauelement erfasst werden kann, ohne dass der Bestückkopf für die Bauelementerkennung einen weiten zusätzlichen Verfahrweg zurücklegen muss. Dies bedeutet, dass die Kamera zwischen einer Bauelement-Zuführeinheit, von der das zu erkennende Bauelement abgeholt wird, und einem Bestückbereich, in dem das erkannte Bauelement auf einen Schaltungsträger platziert wird, angeordnet ist. Ferner kann die Kamera auch direkt am Bestückkopf angeordnet sein, so dass ein aufgenommenes Bauelement während des Transports von der Bauelement-Zuführeinheit hin zu dem Bestückbereich erkannt werden kann. Damit kann in bekannter Weise die Position des Bauelements relativ zu dem Bestückkopf bestimmt werden.

Im Falle der gleichzeitigen Aufnahme von mehreren Bauelementen in einem Kamerabild können somit mehrere elektronische Bauelemente gleichzeitig erkannt werden. Bevorzugt wird dabei für jedes Bauteil ein eigenes Modell verwendet. Es kann jedoch auch ein kombiniertes Modell mehrerer Bauelemente für die weitere Bildverarbeitung bzw. Bilderkennung verwendet werden.

Es wird darauf hingewiesen, dass das Bilderkennungssystem zusätzlich zu der Kamera auch noch eine geeignete Beleuchtungseinheit aufweisen kann, so dass die zu erkennenden Bauelemente unter möglichst optimalen Lichtverhältnissen von der Kamera erfasst werden können.

Gemäß einem weiteren Ausführungsbeispiel der Erfindung nach Anspruch 18 ist die Kamera eine Zeilenkamera. Dies bedeutet, dass eine ggf. hochdynamische Bewegung eines Bestückkopfes, welcher das zu erfassende Bauelement aufgenommen hat, während der Bildaufnahme nicht angehalten werden muss. Bei Verwendung einer Zeilenkamera wird das elektronische Bauelement durch eine sequentielle Aufnahme von einer Vielzahl von Bildzeilen erfasst. Dabei wird das Bauelement relativ zu der Zeilenkamera entlang einer Bewegungsrichtung verfahren, welche senkrecht zu der Längsrichtung des verwendeten Zeilensensors verläuft. Der Bestückkopf muss somit zur Bauelementvermessung nicht angehalten werden, so dass bei einer geeigneten räumlichen Anordnung des Zeilensensors relativ zu dem üblichen Verfahrweg des Bestrückkopfes die Zeitspanne vom Abholen des Bauelements bis hin zum Aufsetzen des Bauelements erheblich verkürzt werden kann. Somit kann die Bestückleistung eines entsprechenden Bestückautomaten auf vorteilhafte Weise erhöht werden.

Mit dem nebengeordneten Patentanspruch 19 wird ein Bestückautomat zum Bestücken von Bauelementeträgern mit elektronischen Bauelementen beschrieben. Der Bestückautomat weist ein Bilderkennungssystem der oben beschriebenen Art auf.

Mit dem nebengeordneten Patentanspruch 20 wird ein Computerlesbares Speichermedium beschrieben. In dem Speichermedium ist ein Programm zum automatischen Erkennen eines elektronischen Bauelementes gespeichert. Das Programm ist, wenn es von einem Prozessor ausgeführt wird, zum Durchführen des oben beschriebenen Verfahrens zum automatischen Erkennen eines elektronischen Bauelementes mittels Bildverarbeitung eingerichtet.

Mit dem nebengeordneten Patentanspruch 21 wird ein Programm-Element zum automatischen Erkennen eines elektronischen Bauelementes beschrieben. Das Programm-Element ist, wenn es von einem Prozessor ausgeführt wird, zum Durchführen des oben beschriebenen Verfahrens zum automatischen Erkennen eines elektronischen Bauelementes mittels Bildverarbeitung eingerichtet.

Das Programm-Element kann als computerlesbarer Anweisungscode in jeder geeigneten Programmiersprache wie beispielsweise in JAVA, C++ etc. implementiert sein. Das Programm-Element kann auf einem computerlesbaren Speichermedium (CD-Rom, DVD, Wechsellaufwerk, flüchtiger oder nicht-flüchtiger Speicher, eingebauter Speicher/Prozessor etc.) abgespeichert sein. Der Anweisungscode kann einen Computer oder andere programmierbare Geräte derart programmieren, dass die gewünschten Funktionen ausgeführt werden. Ferner kann das Programm-Element in einem Netzwerk wie beispielsweise dem Internet bereitgestellt werden, von dem es bei Bedarf von einem Nutzer herunter geladen werden kann.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
Figur 1 zeigt eine perspektivische Darstellung einer Bestückvorrichtung zur Durchführung des Verfahrens zum automatischen Erkennen eines von einer Bauelement-Haltevorrichtung aufgenommenen elektronischen Bauelementes.
Figur 2a und 2b zeigen zwei verschiedene Ausführungsvarianten eines Bauelements, welche Ausführungsvarianten sich durch unterschiedlich ausgebildete Kühlkörper unterscheiden.
Figur 2c zeigt schematisch die Berücksichtigung der in den Figuren 2a und 2b dargestellten unterschiedlichen Ausführungsvarianten in einer geometrischen Beschreibung des Bauelements, welche Beschreibung zwei alternative Merkmale umfasst.
Figur 3 zeigt ein Flussdiagramm eines Verfahrens zur automatischen Erkennung eines Bauelements gemäß einem Ausführungsbeispiel der Erfindung.
Figur 4 zeigt eine perspektivische Ansicht eines als Spulenkörper ausgebildeten Gebindes, auf dem ein mit elektronischen Bauelementen befüllter Bauelement-Gurt aufgewickelt ist und an dem ein Identifizierungselement angebracht ist, welches einen Identifizierungscode für die elektronischen Bauelemente aufweist.

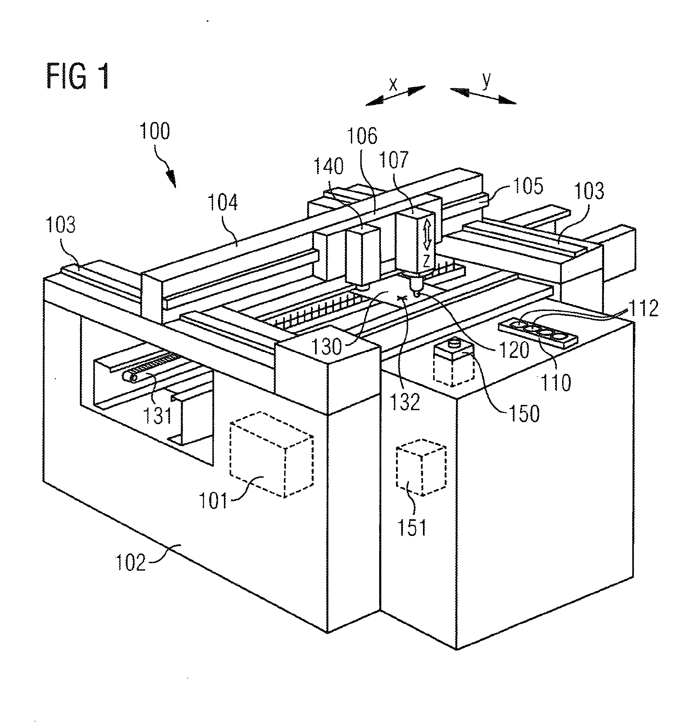

Figur 1 zeigt einen Bestückautomaten 100, welcher einen Rahmen 102 aufweist, an dem zwei parallel ausgerichtete Führungen 103 angebracht sind. Die beiden Führungen 103 tragen einen quer stehenden Trägerarm 104. Der quer stehende Trägerarm 104 weist eine Führung 105 auf, an welcher ein Trägerelement 106 verschiebbar gelagert ist. Die beiden Führungen 103 verlaufen entlang einer y-Richtung, die Führung 105 verläuft entlang einer x-Richtung. An dem Trägerelement 106 ist ein Bestückkopf 107 angeordnet, welcher zumindest eine als Saugpipette 120 ausgebildete Bauelement-Haltevorrichtung aufweist, die mittels eines nicht dargestellten Antriebs entlang einer zu der x- und zu der y-Richtung senkrechten z-Richtung verschiebbar ist.

Um die Winkellage von aufgenommenen Bauelemente zu korrigieren und um somit die Bauelemente korrekt bestücken zu können, ist ferner ein nicht dargestellter Drehantrieb vorgesehen. Mittels des Drehantriebs kann die Saugpipette 120 um ihre Längsachse gedreht werden.

Der Bestückautomat 100 weist ferner eine Bauelement-Zuführeinrichtung 112 auf, über welche in Figur 1 nicht dargestellte Bauelemente dem Bestückprozess zugeführt werden können. Ferner umfasst der Bestückautomat 100 ein Förderband 131, mit dem eine zu bestückende Leiterplatte 130 in den Bestückbereich eingebracht werden kann. Die Saugpipette 107 kann durch eine entsprechende Bewegung des Bestückkopfes 107 innerhalb der x-y-Ebene innerhalb des gesamten Bestückbereichs positioniert werden.

Der Bestückautomat 100 weist außerdem einen Prozessor bzw. eine zentrale Steuereinheit 101 auf. Auf der Steuereinheit 101 kann ein Bearbeitungsprogramm für den Bestückautomaten 100 zum Bestücken von Bauelementeträgern 130 mit Bauelementen ausgeführt werden, so dass alle Komponenten des Bestückautomaten 100 in synchronisierter Weise arbeiten und somit zu einem fehlerfreien und zügigem Bestücken von Bauelementeträgern 130 mit Bauelementen beitragen.

An dem Trägerelement 106 ist zusätzlich eine sog. Leiterplatten-Kamera 140 befestigt, welche zur Erfassung einer an der Leiterplatte 130 angebrachten Markierung 132 vorgesehen ist. Auf diese Weise kann die genaue Position der in dem Bestückbereich eingebrachten Leiterplatte 130 durch eine Lagevermessung der Markierung 132 innerhalb des Gesichtsfeldes der Leiterplattenkamera 140 bestimmt werden.

Zur Positionsvermessung und zur Kontrolle von aufgenommenen Bauelementen ist eine Kamera 150 vorgesehen, welche gemäß dem hier dargestellten Ausführungsbeispiel in einer festen Position an dem Bestückautomaten 100 angeordnet ist. Die optische Bauelement-Vermessung erfolgt bevorzugt unmittelbar nach der Aufnahme des Bauelements von der Bauelement-Zuführeinrichtung 110 durch eine entsprechende Positionierung des Bestückkopfes 107 oberhalb der Bauelementekamera 150. Das von der Kamera 150 aufgenommene Bild wird in einer Datenverarbeitungseinrichtung 151 ausgewertet. Dabei wird sowohl eine Erkennung des aufgenommenen Bauelement-Typs als auch eine Positionsbestimmung des aufgenommenen Bauelements durchgeführt. Bei der Positionsbestimmung wird der Versatz des von der Saugpipette 120 aufgenommenen Bauelements relativ zu der Saugpipette 120 bzw. relativ zu dem Bestückkopf 107 ermittelt.

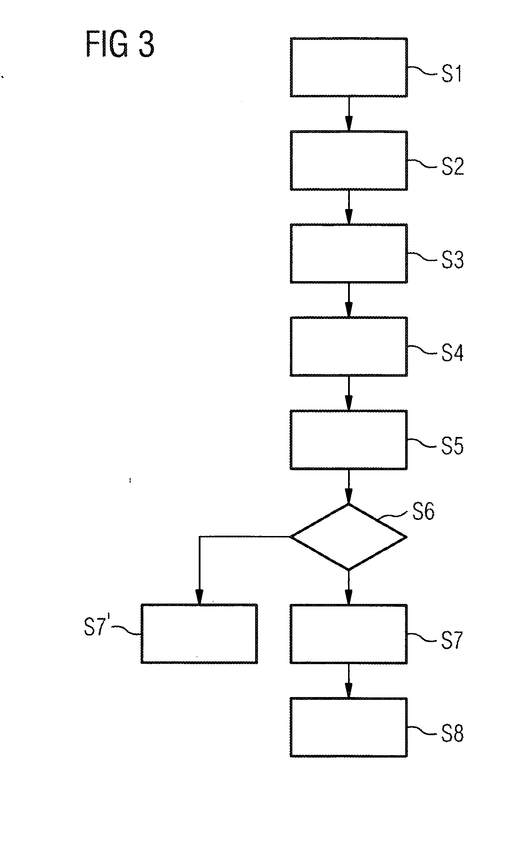

Die Erkennung sowie die Positionsbestimmung des Bauelements erfolgt mittels einer Abfolge von verschiedenen Bildverarbeitungsschritten, welche nachfolgend anhand von Figur 3 näher erläutert werden.

Die Datenverarbeitungseinrichtung 151 kann auch in der zentralen Steuereinheit 101 integriert sein. Dabei kann die Datenverarbeitungseinrichtung 151 mittels einer eigenen Hardware oder auch mittels einer geeigneten Software realisiert sein.

Es wird darauf hingewiesen, dass die Erfindung keineswegs auf die Verwendung in dem hier dargestellten Bestückautomaten 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition hin zu der Bestückposition zu vermessen.

Ebenso kann die Erfindung im Zusammenhang mit einem sog. Mehrfach-Bestückkopf eingesetzt werden, welcher mehrere Haltevorrichtungen aufweist und somit gleichzeitig mehrere Bauelemente transportieren kann. Dabei können die Haltevorrichtungen zeilen- bzw. matrixartig angeordnet sein. Ebenso können die Haltevorrichtungen jedoch auch um eine Rotationsachse radial abstehen abgeordnet sein, so dass durch eine Drehung der Haltevorrichtungen mehrere Bauelemente sequentiell aufgenommen und auch wieder abgesetzt werden können. Selbstverständlich kann die Erfindung jedoch auch mit beliebigen anderen Arten von Einfach- oder Mehrfach-Bestückköpfen realisiert werden.

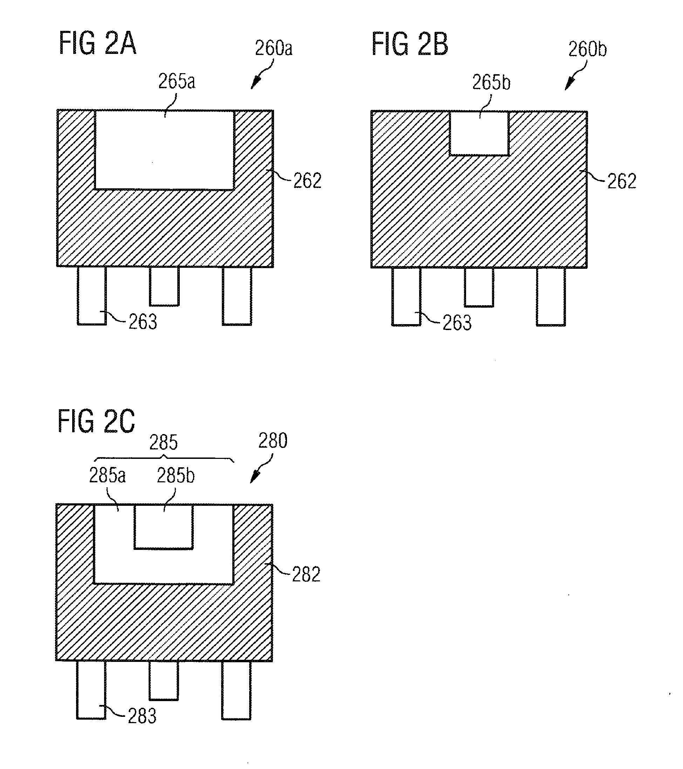

Figur 2a und 2b zeigen zwei verschiedene Ausführungsvarianten eines Bauelements 260a, 260b, welche Ausführungsvarianten sich durch unterschiedlich ausgebildete Kühlkörperformen unterscheiden. Das in Bauelement 260a, 260b ist ein so genanntes D-PACK Bauelement, welches einen Kühlkörper 265a, 265b aufweist. Das Bauelement 260a, 260b weist einen Gehäusekörper 262 auf, aus welchem elektrische Anschlussfüße 263 herausragen. Ferner weist das Bauelement 260a, 260b einen Kühlkörper 265a, 265b auf. Obwohl die elektronischen bzw. elektrischen Eigenschaften der Bauelemente 260a und 260b die gleichen sind, ist der Kühlkörper 265a des Bauelements 260a deutlich größer als der Kühlkörper 265b des Bauelements 260b.

Um unabhängig von der speziellen Ausführungsvariante das Bauelement 260a, 260b mittels eines Bildverarbeitungsprogramms zuverlässig erkennen zu können, werden gemäß dem hier dargestellten Ausführungsbeispiel der Erfindung beide Ausführungsvarianten mittels eines gemeinsamen geometrischen Modells 280 beschrieben. Dieses gemeinsame Modell 280 ist in Figur 2c schematisch dargestellt. Dabei werden die verschiedenen Varianten der Kühlfahne 265a, 265b des D-PACK Bauelements als alternative Merkmalsvarianten 285a und 285b eines Merkmals 285 in das Modell 280 aufgenommen. Bei der Erkennung wird dann versucht, in einem aufgenommenen Bild neben den Merkmalen 282 des Gehäusekörpers 262 und den Merkmalen 283 der Anschlussfüße 263 auch zumindest entweder das Merkmal 285a, welches der Kühlfahne 265a entspricht, oder das Merkmal 285b, welches der Kühlfahne 265b entspricht, zu identifizieren. Sollte zumindest eines dieser Merkmale 285a, 285b im Bild identifiziert werden, dann wird das Bauelement 260a bzw. 260b als erkannt angesehen. Dies bedeutet, dass unabhängig von der jeweiligen konkreten Ausführungsvariante das Bauelement 260a bzw. 260b erkannt wird. Damit ist sicher gestellt, dass das von einer entsprechenden Bauelement-Haltevorrichtung aufgenommene Bauelement auch tatsächlich die gewünschte elektronische Funktionalität aufweist und der Bestückprozess entsprechend fortgesetzt werden kann.

Figur 3 zeigt ein Flussdiagramm eines bevorzugten Ausführungsbeispiels der Erfindung. Bei dem beschriebenen Verfahren, welches acht Schritte S1 bis S8 aufweist, wird ein von einer Bauelement-Haltevorrichtung aufgenommenes elektronisches Bauelement mittels Bildverarbeitung erkannt und die Position des Bauelements relativ zu der Haltevorrichtung ermittelt.

In einem ersten Schritt S1 wird ein geometrisches Modell des Bauelements an die Datenverarbeitungseinrichtung übergeben. Gemäß dem hier dargestellten Ausführungsbeispiel weist das geometrische Modell zumindest ein Merkmal auf, welches verschiedenen alternative Varianten umfasst.

In einem zweiten Schritt S2 wird das zu erkennende Bauelement durch eine geeignete Positionierung eines der Bauelement-Haltevorrichtung zugeordneten Bestückkopfes in das Gesichtsfeld einer Kamera gebracht.

In einem nachfolgenden Schritt S3 nimmt die Kamera ein Bild des Bauelements auf. Dabei kann die Art und Weise der Bildaufnahme von dem gewählten geometrischen Modell abhängen, welches zuvor in Schritt 1 an die Datenverarbeitungseinrichtung übergeben wurde. Die Bildqualität kann dabei maßgeblich durch eine geeignete Beleuchtung des Bauelements verbessert werden. Die optimalen Beleuchtungseinstellungen können dabei von dem gewählten geometrischen Modell abhängen.

Das gewählte geometrische Modell kann auch einen bestimmten Bildausschnitt vorgeben, in welchem die zu erkennenden Merkmale des Bauelements erwartet werden. In diesem Fall muss dann nur dieser Bildausschnitt mittels eines sog. "Partial Scans" von der Kamera erfasst werden. Auf diese Weise kann die zu verarbeitende Datenmenge erheblich reduziert werden, indem lediglich der entsprechende Teil des Bauelements von der Kamera aufgenommen wird und der weiteren Bildverarbeitung zugrunde gelegt wird.

Nach der Aufnahme des Bildes werden in einem Schritt S4 die entsprechenden Bilddaten an eine Datenverarbeitungseinrichtung übergeben.

In einem Schritt S5 werden die Merkmale des Modells mit Merkmalen des aufgenommenen Bildes verglichen. Im Falle eines kombinierten Vergleichs von mehreren Merkmalen werden einander entsprechende Merkmale jeweils paarweise miteinander verglichen. Das Vergleichen der Merkmale des Modells mit den Merkmalen des Bildes umfasst dabei mehrere einzelne Bildverarbeitungsschritte. Unter anderem werden dabei aus dem geometrischen Modell bestimmte Parameter für Bildverarbeitungsoperatoren abgeleitet, welche Parameter zur Suche bestimmter weiterer Merkmale in dem Bild verwendet werden. Die Bildverarbeitungsoperatoren sind geometrische Filter und/oder Profil-Operatoren.

In einem nachfolgenden Schritt S6 wird dann ermittelt, ob die Merkmale in dem aufgenommenen Bild mit den Merkmalen des geometrischen Models innerhalb gewissen Toleranzen miteinender übereinstimmen. Dabei wird bei einem Vergleich eines Merkmals, welches in dem geometrischen Modell des Bauelements mit mehreren alternativen Varianten beschrieben ist, bereits dann eine Übereinstimmung angenommen, wenn das entsprechende Merkmal des Bauelementes innerhalb einer vorgegebenen Toleranz einer der Varianten entspricht. Für den Fall, dass ein Merkmal des Bildes mehreren Varianten des entsprechenden Merkmals des Modells zugeordnet werden kann, kann diejenige Variante ausgewählt werden, welche den höchsten Grad an Übereinstimmung mit dem Bildmerkmal aufweist.

Bei dem beschriebenen Verfahren wird dann abhängig von dem Ergebnis des Schrittes S6 entweder ein Schritt S7 oder ein Schritt S7' ausgeführt.

Im Falle einer nicht gefundenen Übereinstimmung wird in dem Schritt S7' das von der Bauelement-Haltevorrichtung aufgenommene Bauelement als unbekanntes Bauelement angesehen. Um eine korrekte Bestückung eines Bauelementeträgers zu gewährleisten, wird das unbekannte Bauelement verworfen bzw. aus dem Bestückprozess entfernt. Das beschriebene Verfahren ist damit beendet. Selbstverständlich kann ein neues Bauelement von dem Bestückkopf aufgenommen und der oben beschriebene Erkennungsprozess erneut durchgeführt werden.

Im Falle einer gefundenen Übereinstimmung wird in dem Schritt S7 das Bauelement als erkannt angesehen und die Position des Bauelements relativ zu der Bauelement-Haltevorrichtung bzw. relativ zu dem Bestückkopf ermittelt.

Nachfolgend wird in einem Schritt S8 das Bauelement unter Berücksichtung der zuvor ermittelten Positionsdaten an geeigneter Stelle auf einen Bauelementeträger aufgesetzt. Dabei wird eine ggf. vorhandene Positionsabweichung des aufgenommenen Bauelements durch eine entsprechende Positionierung des Bestückkopfes kompensiert. Ebenfalls kann eine ggf. vorhandene Abweichung der Winkellage des aufgenommenen Bauelements von einer Soll-Winkellage durch einen Drehantrieb kompensiert werden, welcher in bekannter Weise mit der entsprechenden Bauelement-Haltevorrichtung gekoppelt sein kann.

Das beschriebene Verfahren hat den Vorteil, dass eine robuste und zuverlässige Erkennung von Bauelementen auch dann möglich ist, wenn das jeweilige Bauelement mit einer großen Variation von Merkmalsformen vorliegen kann. Das beschriebene Erkennungsverfahren hat ferner den Vorteil, dass es bei einem Chargenwechsel nicht notwendig ist manuell auf ein anderes geometrisches Modell umzuschalten. Bei einer entsprechenden Berücksichtigung der chargenabhängigen alternativen Merkmale erfolgt die Umschaltung quasi automatisch.

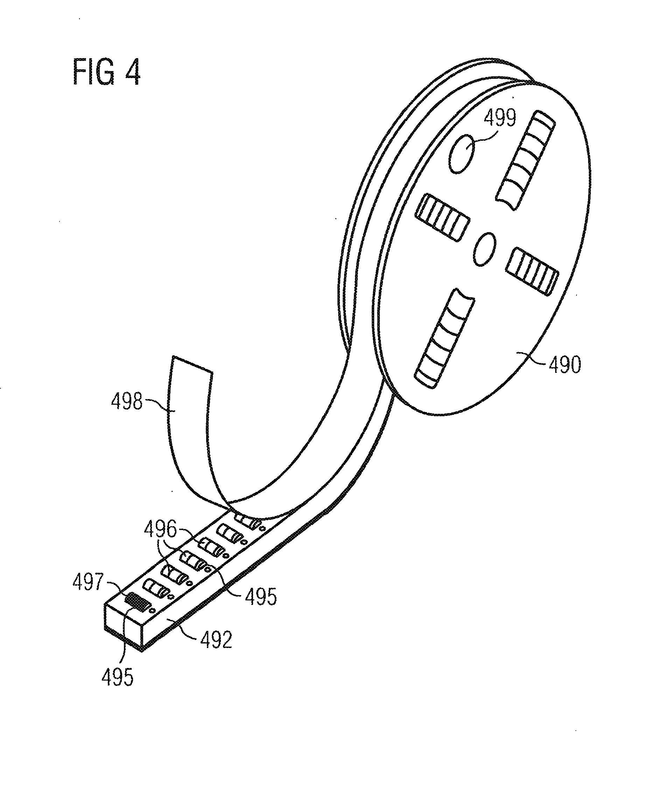

Figur 4 zeigt eine perspektivische Ansicht eines Gebindes 490, welches als Spulenkörper 490 ausgebildet ist. Auf dem Spulenkörper 490 ist ein Bauelement-Gurt 492 aufgewickelt, welcher eine Vielzahl von Ausnehmungen 495 aufweist. Die Ausnehmungen 495 dienen vorwiegend der Aufnahme von jeweils einem elektronischen Bauelement 496.

Der Bauelement-Gurt 492 wird in bekannter Weise mittels einer Bauelement-Zuführvorrichtung hin zu einer Bauelement-Aufnahmeposition transportiert, so dass die Bauelemente 496 sequentiell von einem Bestückkopf entnommen werden können. Um ein unbeabsichtigtes Herausfallen der Bauelemente zu verhindern, ist zusätzlich eine Abdeckfolie 498 vorgesehen, welche erst kurz vor der Aufnahmeposition mittels eines geeigneten nicht dargestellten Abzugsmechanismus von dem Gurt 492 entfernt wird.

Zumindest eine der Ausnehmungen 495 kann der Aufnahme eines Datenträgers 497 dienen, welcher berührungslos ausgelesen werden kann. Gemäß dem hier dargestellten Ausführungsbeispiel ist der Datenträger ein RFID-Chip 497, in dem bauelement-bezogene Daten gespeichert sind. So kann der RFID-Chip 497 beispielsweise die Information enthalten, wie viele Bauelemente noch in dem betreffenden Bauelement-Gurt 492 vorhanden sind.

In dem RFID-Chip 497 kann ferner ein Identifikationscode gespeichert sein, welcher Informationen über die Beschreibung des genauen Typs der Bauelemente 496 enthält. Diese Informationen können genutzt werden, um das oben beschriebene Verfahren zur automatischen Erkennung der Bauelemente 496 durchzuführen.

Das Auslesen des RFID-Chips 497 kann automatisch ohne einen Bedieneingriff einer Bedienperson durch ein geeignetes Lesegerät erfolgen, welches beispielsweise einer nicht dargstellten Bauelement-Zuführeinrichtung zugeordnet ist. Sofern die Position des RFID-Chips 497 relativ zu dem Anfang des Bauelement-Gurtes 492 bekannt ist, ist damit im Falle einer sog. Spleißverbindung mit einem anderen Bauelement-Gurt automatisch ein Bezug zu der Spleiß-Verbindungsstelle zu einem vorherigen Bauelement-Gurt 492 hergestellt. Eine in dem RFID-Chip 497 gespeicherte Bauelementbeschreibung kann damit sofort zur Bauelement-Erkennung im Rahmen des zuvor beschriebenen Verfahrens verwendet werden, wenn die Bauelemente des angespleißten Gurtes verarbeitet werden sollen.

An dem Spulenkörper 499 kann ferner ein als Barcode oder ein als Matrix-Code ausgebildetes Identifizierungselement 499 angebracht sein. Das Identifizierungselement 499 enthält einen Identifizierungscode, welcher bauelement-bezogene Daten der Bauelemente 496 repräsentiert.

Das Identifizierungselement 499 kann in bekannter Weise beispielsweise im Rahmen eines Spleißvorgangs oder einer Rüstverifikation von einer Bedienperson mittels eines nicht dargestellten Handscanners ausgelesen werden. Der auf dem Identifizierungselement 499 gespeicherte Identifizierungscode mit einer Bauelementbeschreibung der nachfolgenden Bauelemente wird dann einer Maschinensteuereinheit des Bestückautomaten mitgeteilt. Sobald beispielsweise mittels einer Spleißstellenerfassungseinheit erkannt wird, dass die neuen Bauelemente für den Bestückungsprozess verwendet werden, dann wird die neue Bauelementbeschreibung zur automatischen Erkennung der zu bestückenden Bauelemente verwendet.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestückvorrichtung
- 101: Prozessor
- 102: Rahmen
- 103: Führungen
- 104: quer stehender Trägerarm
- 105: Führung
- 106: Trägerelement
- 107: Bestückkopf
- 110: Bauelement-Zuführeinrichtung
- 112: Abholposition
- 120: Haltevorrichtung / Sauggreifer / Saugpipette
- 130: Bauelementeträger / Leiterplatte
- 131: Förderband
- 132: Markierung
- 140: Leiterplatten-Kamera
- 150: Sensorvorrichtung / Kamera
- 151: Datenverarbeitungseinrichtung

- 260a: Bauelement (Variante 1)
- 260b: Bauelement (Variante 2)
- 262: Gehäusekörper
- 263: Anschlussfüße
- 265a: Kühlkörper / Kühlfahne (Variante 1)
- 265b: Kühlkörper / Kühlfahne (Variante 2)
- 280: geometrisches Modell / Beschreibung Bauelement
- 282: Modellierung Gehäusekörper
- 283: Modellierung Anschlussfüße
- 285: Modellierung Kühlkörper / Kühlfahne
- 285a: Modellierung Kühlkörper / Kühlfahne (Variante 1)
- 285b: Modellierung Kühlkörper / Kühlfahne (Variante 2)
- S1: Geometrisches Modell des Bauelements mit alternativen Merkmalen wird an die Datenverarbeitungseinrichtung übergeben
- S2: Bauelement wird vor einer Kamera positioniert
- S3: Kamera nimmt ein Bild des Bauelements auf
- S4: Bilddaten werden an eine Datenverarbeitungseinrich- tung übergeben
- S5: Merkmale des Modells werden mit Merkmalen des Bildes verglichen
- S6: Übereinstimmung der Merkmale innerhalb einer bestimm- ten Toleranz ?
- S7: Falls Ja: Bauelement wird als erkannt angesehen und Position des Bauelement relativ zu der Bauelement- Haltevorrichtung bzw. relativ zu dem Bestückkopf wird ermittelt
- S7': Falls Nein: Bauelement wird als unbekannt angesehen und Bauelement wird verworfen und aus dem Bestückprozess entfernt
- S8: Bauelement wird unter Berücksichtung der ermittelten Positionsdaten an geeigneter Stelle auf einen Bauele- menteträger aufgesetzt.

- 490: Gebinde
- 492: Bauelement-Gurt
- 495: Ausnehmungen
- 496: Bauelement
- 497: Datenträger, RFID-Chip
- 498: Abdeckfolie
- 499: Identifizierungselement

## Patentansprüche

1. Verfahren zum automatischen Erkennen eines elektronischen Bauelementes (260a, 260b) mittels Bildverarbeitung, das Verfahren aufweisend folgende Schritte:
• Laden eines Datensatzes mit unterschiedlichen Beschreibungen des optischen Erscheinungsbildes des elektronischen Bauelements (260a, 260b) in eine Datenverarbeitungseinrichtung (151),
• Laden eines von einer Kamera (150) aufgenommenen Bildes von zumindest einem Teil des elektronischen Bauelements (260a, 260b) in die Datenverarbeitungseinrichtung (151), und
• Vergleichen von zumindest einem Merkmal der unterschiedlichen Beschreibungen mit zumindest einem Merkmal (265a, 265b) des Bildes, wobei
das Bauelement (260a, 260b) als dem Datensatz entsprechend erkannt wird, wenn
das zumindest eine Merkmal (260a, 260b) des Bildes innerhalb einer vorgegebenen Toleranz zumindest einem Merkmal des Datensatzes entspricht.

2. Verfahren nach Anspruch 1, wobei
die Beschreibung eine geometrische Beschreibung (280) der Gehäuseform des Bauelements (260a, 260b) ist.

3. Verfahren nach einem der Ansprüche 1 bis 2, wobei
das in die Datenverarbeitungseinrichtung (151) geladene Bild ein von einer Bauelement-Haltevorrichtung (120) aufgenommenes elektronisches Bauelement (260a, 260b) darstellt.

4. Verfahren nach einem der Ansprüche 1 bis 3, zusätzlich aufweisend den Schritt:
Ermitteln der räumlichen Lage des Modells (280) des Bauelements relativ zu dem von der Kamera (150) aufgenommenen Bild.

5. Verfahren nach einem der Ansprüche 1 bis 4, wobei
• der Datensatz ein Modell (280) des optischen Erscheinungsbildes des elektronischen Bauelements (260a, 260b) umfasst, welches Modell (280) ein Merkmal (285) aufweist, welches verschiedene alternative Varianten (285a, 285b) umfasst, und wobei
• das Bauelement (260a, 260b) als dem Datensatz entsprechend erkannt wird, wenn das Merkmal (260a, 260b) des Bildes innerhalb einer vorgegebenen Toleranz zumindest einer alternativen Variante (285a, 285b) des Merkmals entspricht.

6. Verfahren nach Anspruch 5, wobei
ein Merkmal (285) des Modells (280) aus einer vorgegebenen Region des Modells (280) mit
einem Merkmal (265a, 265b) des Bildes aus einer Bildregion verglichen wird, welche Bildregion der vorgegebenen Region des Modells (280) zugeordnet ist.

7. Verfahren nach einem der Ansprüche 5 bis 6, wobei
sich die Varianten des Merkmals (285) bezüglich der Form, der Größe, der Lage, der Farbe, der Helligkeit, des Kontrastes und/oder der Kontrastrichtung
von bestimmten räumlichen Bereichen des Modells (280) des optischen Erscheinungsbildes des elektronischen Bauelements (260a, 260b) unterscheiden.

8. Verfahren nach einem der Ansprüche 5 bis 7, wobei
das Modell (280) des optischen Erscheinungsbildes des elektronischen Bauelements (260a, 260b) zumindest ein weiteres Merkmal (282, 283) aufweist, und wobei
das Verfahren zusätzlich den folgenden Schritt aufweist:
• Vergleichen des weiteren Merkmals (282, 283) des Modells mit einem weiteren Merkmal (262, 263) des Bildes, wobei das Bauelement (260a, 260b) als dem Modell (280) entsprechend erkannt wird, wenn
(a) das Merkmal (265a, 265b) des Bildes innerhalb einer vorgegebenen Toleranz zumindest einer alternativen Variante (285a, 285b) des Merkmals (285) des Modells (280) entspricht und wenn
(b) das weitere Merkmal (262, 263) des Bildes innerhalb einer vorgegebenen weiteren Toleranz dem weiteren Merkmal (282, 283) des Modells entspricht.

9. Verfahren nach Anspruch 8, wobei
das weitere Merkmal (282, 283) des Modells (280) verschiedene alternative weitere Varianten umfasst.

10. Verfahren nach einem der Ansprüche 8 bis 9, wobei
mit dem Merkmal (285) des Modells (280) und mit dem zumindest einen weiteren Merkmal (282, 283) des Modells (280) eine Merkmalsgruppe definiert wird, welche abhängig von der Anzahl der verschiedenen alternativen Varianten (285a, 285b) des Merkmals (285) eine entsprechende Anzahl von verschiedenen Merkmalskombinationen umfasst.

11. Verfahren nach einem der Ansprüche 1 bis 4, wobei der Datensatz voneinander unabhängige unterschiedliche Beschreibungen des optischen Erscheinungsbildes des elektronischen Bauelements (260a, 260b) aufweist.

12. Verfahren nach Anspruch 11, zusätzlich aufweisend folgende Schritte:
• Laden eines Identifikationscodes in die Datenverarbeitungseinrichtung (151), welcher Identifikationscode einer der unterschiedlichen Beschreibungen des optischen Erscheinungsbildes des elektronischen Bauelements (260a, 260b) zugeordnet ist, und
• Selektieren einer bevorzugten Beschreibung basierend auf dem Identifikationscode, wobei
die bevorzugte Beschreibung für den Schritt des Vergleichens von zumindest einem Merkmal der unterschiedlichen Beschreibungen mit zumindest einem Merkmal (265a) des Bildes bevorzugt verwendet wird.

13. Verfahren nach Anspruch 12, wobei
der Identifikationscode an einem Identifikationselement (499) gespeichert ist, welches an einem Bauelementmagazin (490) angebracht ist.

14. Verfahren nach einem der Ansprüche 12 bis 13, wobei das Laden des Identifikationscodes durch einen automatischen Einlesevorgang erfolgt.

15. Verfahren nach Anspruch 14, wobei
der Identifikationscode
durch ein einer Bauelement-Zuführeinheit zugeordnetes Lesegerät oder durch ein von einer Bedienperson gehandhabtes Handlesegerät eingelesen wird.

16. Bilderkennungssystem zum automatischen Erkennen eines elektronischen Bauelementes, das Bilderkennungssystem aufweisend:
• einen Prozessor (151), der derart eingerichtet ist, dass das Verfahren nach einem der Ansprüche 1 bis 15 durchführbar ist.

17. Bilderkennungssystem nach Anspruch 16, zusätzlich aufweisend
• eine Kamera (150)
zum Aufnehmen eines Bildes des zu erkennenden Bauelements (260a, 260b) oder
zum Aufnehmen eines Bildes von zumindest zwei zu erkennenden Bauelementen.

18. Bilderkennungssystem nach Anspruch 17, wobei die Kamera eine Zeilenkamera ist.

19. Bestückautomat zum Bestücken von Bauelementeträgern (130) mit elektronischen Bauelementen (260a, 260b), der Bestückautomat (100) aufweisend:
• ein Bilderkennungssystem nach einem der Ansprüche 16 bis 18.

20. Computerlesbares Speichermedium, in dem ein Programm zum automatischen Erkennen eines elektronischen Bauelementes (260a, 260b) gespeichert ist, wobei das Programm, wenn es von einem Prozessor (151) ausgeführt wird, zum Durchführen des Verfahrens nach einem der Ansprüche 1 bis 15eingerichtet ist.

21. Programm-Element zum automatischen Erkennen eines elektronischen Bauelementes (260a, 260b), wobei das Programm-Element, wenn es von einem Prozessor (151) ausgeführt wird, zum Durchführen des Verfahrens nach einem der Ansprüche 1 bis 15 eingerichtet ist.

## Claims

1. Method for automatic identification of an electronic component (260a, 260b) by means of image processing, the method comprising the following steps of:
• loading a data record containing different descriptions of the visual appearance of the electronic component (260a, 260b) into a data processing device (151),
• loading an image, recorded by a camera (150), of at least one part of the electronic component (260a, 260b) into the data processing device (151), and
• comparing at least one feature of the different descriptions with at least one feature (265a, 265b) of the image, wherein the component (260a, 260b) is identified as corresponding to the data record if
the at least one feature (265a, 265b) of the image corresponds to at least one feature of the data record within a specified tolerance.

2. Method according to claim 1, wherein
the description is a geometric description (280) of the package shape of the component (260a, 260b).

3. Method according to one of claims 1 to 2, wherein the image loaded into the data processing device (151) represents an electronic component (260a, 260b) picked by a component gripping device (120).

4. Method according to one of claims 1 to 3, additionally comprising the step of:
determining the spatial location of the model (280) of the component relative to the image recorded by the camera (150).

5. Method according to one of claims 1 to 4, wherein
• the data record includes a model (280) of the visual appearance of the electronic component (260a, 260b), which model (280) has a feature (285) which includes various alternative variants (285a, 285b), und wherein
• the component (260a, 260b) is identified as corresponding to the data record if the feature (260a, 260b) of the image corresponds to at least one alternative variant (285a, 285b) of the feature within a specified tolerance.

6. Method according to claim 5, wherein
a feature (285) of the model (280) from a specified region of the model (280) is compared with a feature (265a, 265b) of the image from an image region, which image region is assigned to the specified region of the model (280).

7. Method according to one of claims 5 to 6, wherein
the variants of the feature (285) are different in respect of the shape, size, position, colour, brightness, contrast and/or contrast direction from specific spatial regions of the model (280) of the visual appearance of the electronic component (260a, 260b).

8. Method according to one of claims 5 to 7, wherein
the model (280) of the visual appearance of the electronic component (260a, 260b) has at least one further feature (282, 283), and wherein the method additionally comprises the following step of:
• comparing the further feature (282, 283) of the model with a further feature (262, 263) of the image, wherein the component (260a, 260b) is identified as corresponding to the model (280) if
(a) the feature (265a, 265b) of the image corresponds to at least one alternative variant (285a, 285b) of the feature (285) of the model (280) within a specified tolerance and if
(b) the further feature (262, 263) of the image corresponds to the further feature (282, 283) of the model within a specified further tolerance.

9. Method according to claim 8, wherein
the further feature (282, 283) of the model (280) includes various alternative further variants.

10. Method according to one of claims 8 to 9, wherein
a feature group is defined by means of the feature (285) of the model (280) and by means of the at least one further feature (282, 283) of the model (280), which feature group includes a corresponding number of different feature combinations as a function of the number of different alternative variants (285a, 285b) of the feature (285).

11. Method according to one of claims 1 to 4, wherein the data record has different descriptions of the visual appearance of the electronic component (260a, 260b) which are independent of one another.

12. Method according to claim 11, additionally comprising the following steps of:
• loading an identification code into the data processing device (151), which identification code is assigned to one of the different descriptions of the visual appearance of the electronic component (260a, 260b), and
• selecting a preferred description based on the identification code, wherein
the preferred description is preferably used for the step of comparing at least one feature of the different descriptions with at least one feature (265a) of the image.

13. Method according to claim 12, wherein
the identification code is stored on an identification element (499) which is mounted on a component magazine (490).

14. Method according to one of claims 12 to 13, wherein the identification code is loaded by means of an automatic read-in process.

15. Method according to claim 14, wherein
the identification code
is read in by means of a reading device assigned to a component feeder unit or by means of a handheld reading device handled by an operator.

16. Image recognition system for automatic identification of an electronic component, the image recognition system having:
• a processor (151) which is configured in such a way that the method according to one of claims 1 to 15 can be performed.

17. Image recognition system according to claim 16, additionally having
• a camera (150)
for recording an image of the component (260a, 260b) requiring identification or
for recording an image of at least two components requiring identification.

18. Image recognition system according to claim 17, wherein the camera is a line scan camera.

19. Automatic placement machine for mounting electronic components (260a, 260b) on component carriers (130), the automatic placement machine (100) having:
• an image recognition system according to one of claims 16 to 18.

20. Computer-readable storage medium on which a program for automatic identification of an electronic component (260a, 260b) is stored, wherein the program, when it is executed by a processor (151), is configured for performing the method according to one of claims 1 to 15.

21. Program element for automatic identification of an electronic component (260a, 260b), wherein the program element, when it is executed by a processor (151), is configured for performing the method according to one of claims 1 to 15.

## Revendications

1. Procédé d'identification automatique d'un composant électronique (260a, 260b) par traitement d'images, le procédé comportant les étapes suivantes :
- chargement, dans une unité de traitement de données (151), d'un jeu de données avec différentes descriptions de l'aspect visuel du composant électronique (260a, 260b),
- chargement, dans le dispositif de traitement de données (151), d'une image prise par une caméra (150) d'au moins une partie du composant électronique (260a, 260b) et
- comparaison d'au moins une caractéristique des différentes descriptions avec au moins une caractéristique (265a, 265b) de l'image,
le composant (260a, 260b) étant identifié comme conforme au jeu de données lorsque l'au moins une caractéristique (260a, 260b) de l'image correspond à au moins une caractéristique du jeu de données dans les limites d'une tolérance donnée.

2. Procédé selon la revendication 1, la description étant une description géométrique (280) de la forme du boîtier du composant (260a, 260b).

3. Procédé selon l'une des revendications 1 à 2, l'image chargée dans le dispositif de traitement de données (151) représentant un composant électronique (260a, 260b) pris par un dispositif de retenue de composant (120) .

4. Procédé selon l'une des revendications 1 à 3, comportant additionnellement l'étape suivante :
- détermination de la position spatiale du modèle (280) du composant par rapport à l'image prise par la caméra (150).

5. Procédé selon l'une des revendications 1 à 4,
- le jeu de données comportant un modèle (280) de l'aspect visuel du composant électronique (260a, 260b), lequel modèle (280) comporte une caractéristique (285) qui comprend différentes variantes alternatives (285a, 285b) et
- le composant (260a, 260b) étant identifié comme conforme au jeu de données lorsque la caractéristique (260a, 260b) de l'image correspond à au moins une variante alternative (285a, 285b) de la caractéristique dans les limites d'une tolérance donnée.

6. Procédé selon la revendication 5, une caractéristique (285) du modèle (280) tirée d'une région prédéterminée du modèle (280) étant comparée avec une caractéristique (265a, 265b) de l'image tirée d'une région de l'image, laquelle région d'image est associée à la région prédéterminée du modèle (280).

7. Procédé selon l'une des revendications 5 à 6, les variantes de la caractéristique (285) différant par la forme, la taille, la position, la couleur, la luminosité, le contraste et/ou la direction du contraste de certaines zones spatiales du modèle (280) de l'aspect visuel du composant électronique (260a, 260b).

8. Procédé selon l'une des revendications 5 à 7, le modèle (280) de l'aspect visuel du composant électronique (260a, 260b) comportant au moins une autre caractéristique (282, 283) et le procédé comportant additionnellement l'étape suivante :
- comparaison de l'autre caractéristique (282, 283) du modèle avec une autre caractéristique (262, 263) de l'image, le composant (260a, 260b) étant identifié comme conforme au modèle (280) lorsque
a) la caractéristique (265a, 265b) de l'image correspond à au moins une variante alternative (285a, 285b) de la caractéristique (285) du modèle (280) dans les limites d'une tolérance donnée et
b) l'autre caractéristique (262, 263) de l'image correspond à l'autre caractéristique (282, 283) du modèle dans les limites d'une autre tolérance donnée.

9. Procédé selon la revendication 8, l'autre caractéristique (282, 283) du modèle (280) comprenant différentes autres variantes alternatives.

10. Procédé selon l'une des revendications 8 à 9, la caractéristique (285) du modèle (280) et l'au moins une autre caractéristique (282, 283) du modèle (280) définissant un groupe de caractéristiques qui, en fonction du nombre des différentes variantes alternatives (285a, 285b) de la caractéristique (285), comprend un nombre correspondant de différentes combinaisons de caractéristiques.

11. Procédé selon l'une des revendications 1 à 4, le jeu de données comportant différentes descriptions, indépendantes l'une de l'autre, de l'aspect visuel du composant électronique (260a, 260b).

12. Procédé selon la revendication 11, comportant additionnellement les étapes suivantes :
- chargement d'un code d'identification dans le dispositif de traitement de données (151), lequel code d'identification est associé à l'une des différentes descriptions de l'aspect visuel du composant électronique (260a, 260b) et
- sélection d'une description préférentielle sur la base du code d'identification, la description préférentielle étant utilisée pour l'étape de la comparaison d'au moins une caractéristique des différentes descriptions avec au moins une caractéristique (265a) de l'image.

13. Procédé selon la revendication 12, le code d'identification étant stocké sur un élément d'identification (499) qui est situé sur un chargeur de composants (490).

14. Procédé selon l'une des revendications 12 à 13, le chargement du code d'identification étant effectué par une opération de lecture automatique.

15. Procédé selon la revendication 14, le code d'identification étant lu par un appareil de lecture associé à une unité d'amenée de composants ou par un appareil de lecture manuelle manipulé par un opérateur.

16. Système d'identification d'images pour l'identification automatique d'un composant électronique, le système d'identification d'images comportant
- un processeur (151) qui est aménagé de manière à exécuter le procédé selon l'une des revendications 1 à 15.

17. Système d'identification d'images selon la revendication 16, comportant additionnellement
- une caméra (150)
pour prendre une image du composant à identifier (260a, 260b) ou
pour prendre une image d'au moins deux composants à identifier.

18. Système d'identification d'images selon la revendication 17, la caméra étant une caméra linéaire.

19. Automate de pose pour poser des composants électroniques (260a, 260b) sur des supports de composants (130), l'automate de pose comportant
- un système d'identification d'images selon l'une des revendications 16 à 18.

20. Moyen de stockage lisible par ordinateur, dans lequel est stocké un programme d'identification automatique d'un composant électronique (260a, 260b), le programme, lorsqu'il est exécuté par un processeur (151), étant configuré pour exécuter le procédé selon l'une des revendications 1 à 15.

21. Élément de programme pour l'identification automatique d'un composant électronique (260a, 260b), l'élément de programme, lorsqu'il est exécuté par un processeur (151), étant configuré pour exécuter le procédé selon l'une des revendications 1 à 15.
